Europäisches Patentamt

(19) European Patent Office

Office européen des brevets

(11) Publication number: **0 028 916**
A2

(12) # EUROPEAN PATENT APPLICATION

(21) Application number: **80303938.7**

(22) Date of filing: **05.11.80**

(51) Int. Cl.³: **G 11 C 8/00**
**G 11 C 17/00**

(30) Priority: **12.11.79 JP 146346/79**

(43) Date of publication of application:
**20.05.81 Bulletin 81/20**

(84) Designated Contracting States:
**DE FR GB NL**

(71) Applicant: **FUJITSU LIMITED**
**1015, Kamikodanaka Nakahara-ku**
**Kawasaki-shi Kanagawa 211(JP)**

(72) Inventor: **Miyasaka, Kiyoshi**
**577-45, Iijima-cho, Totsuka-ku**
**Yokohama-shi, Kanagawa 244(JP)**

(72) Inventor: **Higuchi, Mitsuo**
**5-13, Yutenji 2-chome**
**Meguro-ku, Tokyo 153(JP)**

(74) Representative: **Massey, Alexander et al,**
**MARKS & CLERK Scottish Life House Bridge Street**
**Manchester, M3 3DP(GB)**

(54) A semiconductor memory device.

(57) A semiconductor memory device includes in its chip a decoder circuit which receives external selection signals for selecting a memory chip. The decoder circuit performs the selection of the memory chip in accordance with a logic corresponding to the combination of the external selection signals. The selection logic can be changed by the user of the semiconductor device.

EP 0 028 916 A2

./...

Fig. 2

## A SEMICONDUCTOR MEMORY DEVICE

### TECHNICAL FIELD

The present invention relates to a semiconductor memory device, and particularly a semiconductor memory device which provides chip selection means. The semiconductor memory device of the present invention is in the form of a ROM, an EPROM, a PROM, an EAROM or a RAM.

### BACKGROUND ART

In the system which uses a plurality of memory chips, it is necessary to conduct a selection of a memory chip in question by an address signal supplied to the system.

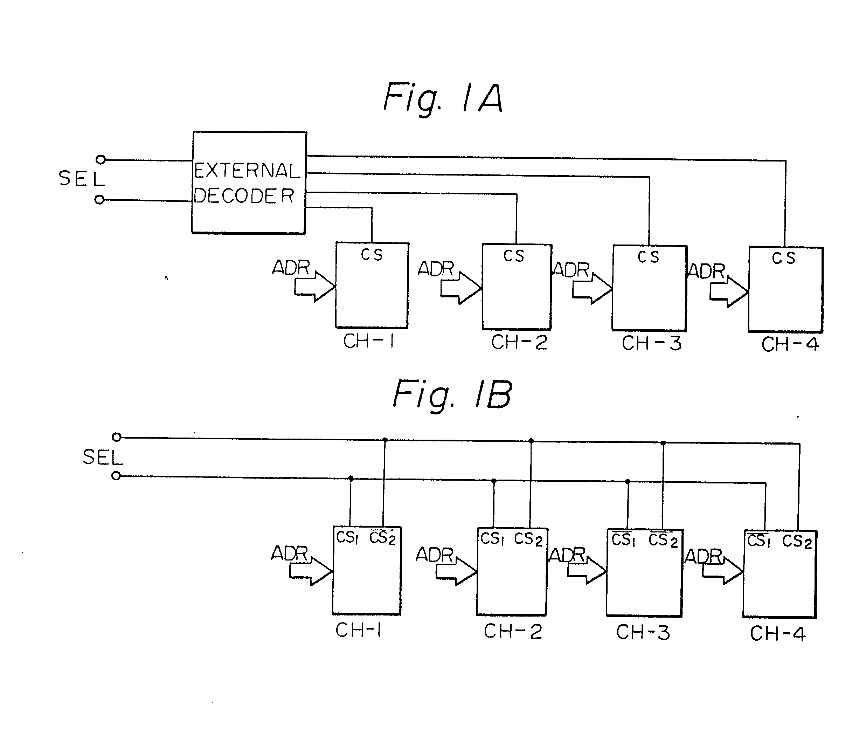

In the prior art systems illustrated in Figs. 1A and 1B, each of the chips CH-1, CH-2, CH-3 and CH-4 provides a chip selection terminal CS or chip selection terminals $CS_1$ ($\overline{CS_1}$) and $CS_2$ ($\overline{CS_2}$). The chips of Fig. 1B are of the Mask ROM type. The chip selection logic is determined in the wafer processing stage. The chip selection signal SEL which occupies the higher bit portions of the address signal ADR is supplied to the external decorder circuit (Fig. 1A) and the chip selection terminals $CS_1$ ($\overline{CS_1}$) and $CS_2$ ($\overline{CS_2}$) (FIG. 1B).

However, the prior art systems of Fig. 1A is disadvantageous, because it is necessary to provide an external decoder circuit DEC to produce the signals for carrying out the chip selection from the chip selection signal SEL.

Also, the prior art system of Fig. 1B is disadvantageous, because it is impossible to change the condition of the signals applied to the chip selection terminals $CS_1$ ($\overline{CS_1}$) and $CS_2$ ($\overline{CS_2}$), if a user of the system of Fig. 1B wants to change the program of the chip selection.

The present invention is directed to eliminate the disadvantages in the prior art semiconductor memory systems described above.

### SUMMARY OF THE INVENTION

In accordance with the present invention, a semiconductor memory device is provided in which the selection of a memory chip is carried out in accordance with the logic of the external selection signals, said semiconductor memory device being characterized in that a decoder circuit for receiving said external selection signals for selecting a memory chip is provided in said chip, said decoder circuit performing the selection of said memory chip in accordance with a logic corresponding to the combination of said external selection signals, said logic being capable of being changed by the user of said semiconductor memory device.

BRIEF DESCRIPTION OF THE DRAWINGS

Figs. 1A and 1B illustrate two prior art systems of the chip selection in a semiconductor memory device,

Fig. 2 illustrates a semiconductor memory device in accordance with an embodiment of the present invention,

Figs. 3A and 3B illustrate the control circuits used in the device of Fig. 2, and,

Fig. 4 illustrates a table indicating a manner of cell selection in the device of Fig. 2.

DESCRIPTION OF THE PREFERRED EMBODIMENTS

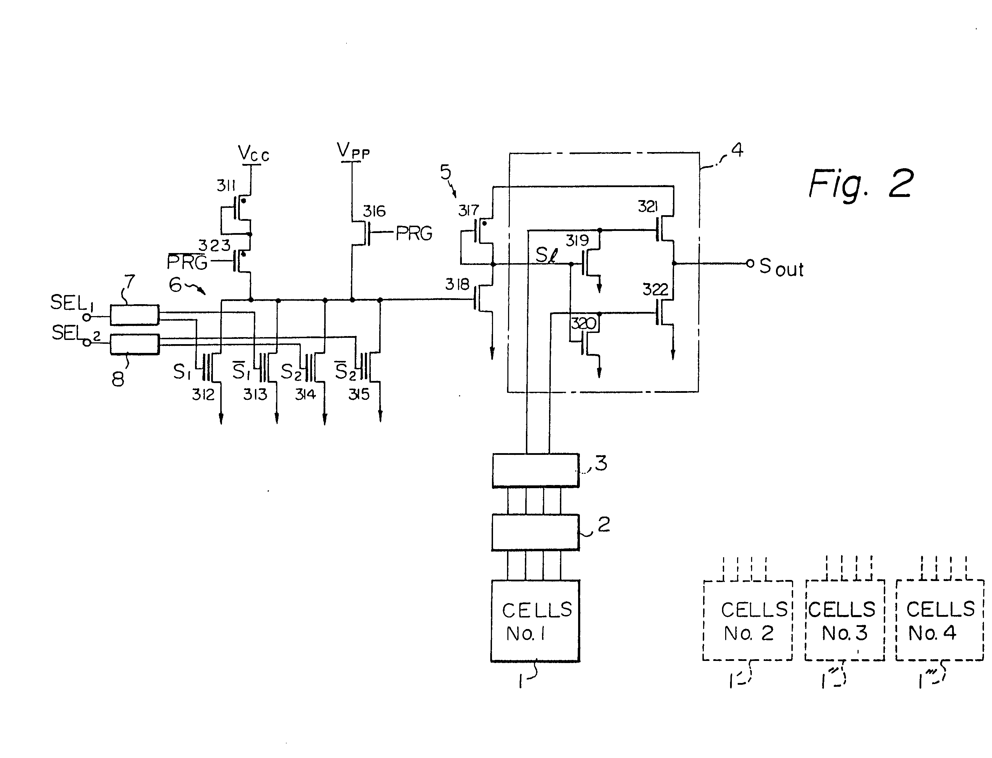

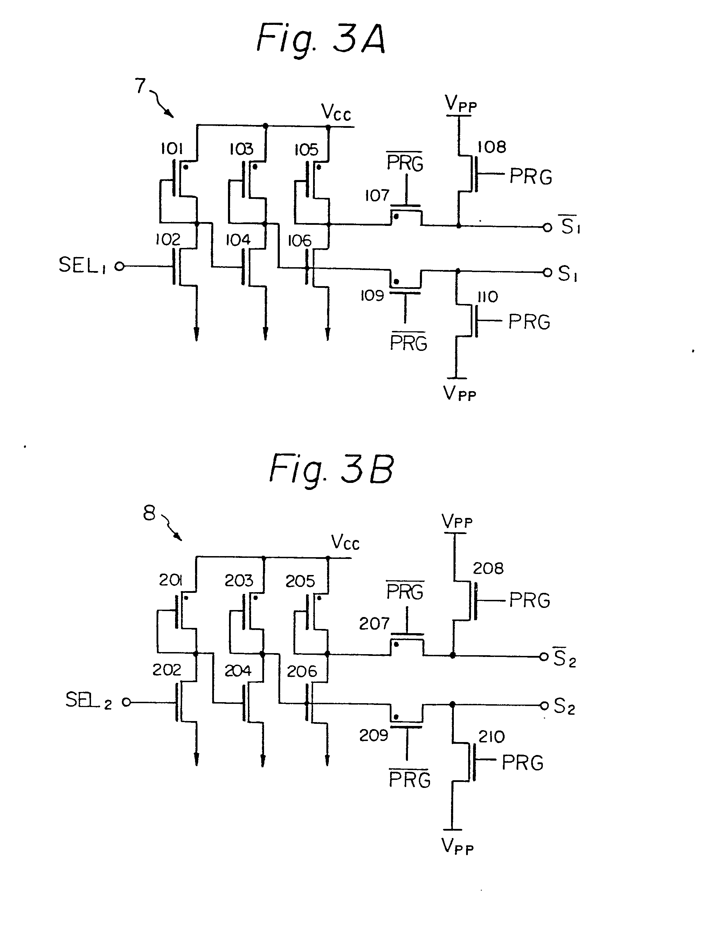

A semiconductor memory device in accordance with an embodiment of the present invention is illustrated in Fig. 2. The semiconductor memory device of Fig. 2 is of an EPROM type. The control circuits 7 and 8 for producing the chip selection signals $S_1$ , $\overline{S_1}$ , $S_2$ and $\overline{S_2}$ , which are applied to the gates of the double gate FAMOS FETs 312, 313, 314 and 315 in the device of Fig. 2, are illustrated in Figs. 3A and 3B.

The control circuit 7 of Fig. 3A comprises depletion type load FETs 101, 103 and 105, enhancement type driver FETs 102, 104 and 106, a voltage source $V_{cc}$ (e.g. 5 volts), a depletion type FET 107, an enhancement type FET 108, a depletion type FET 109, an enhancement type FET 110, and a voltage source $V_{pp}$ (e.g. 25 volt).

The control circuit 8 of Fig. 3B has the structure identical with that of the control circuit 7 of Fig. 3A.

In the writing-in mode, the potential of the signal PRG is HIGH (e.g. 25 volts) and the potential of the signal $\overline{PRG}$ is LOW (0 volt), and accordingly the potentials of the signals $S_1$ and $\overline{S_1}$ are HIGH or LOW in accordance with the potential of the signal $SEL_1$. Said HIGH potential of the signals $S_1$ and $\overline{S_1}$ is equal to the HIGH potential of the signal PRG (e.g. 25 volts) minus the threshold voltage of the FET 108 or FET 110. Said LOW potential of the signals $S_1$ and $\overline{S_1}$ is zero volt. While, in the chip-selection mode, the potential of the signal PRG is LOW (0 volt) and the potential of the signal $\overline{PRG}$ is HIGH (e.g. 5 volts), and accordingly the potentials of the signals $S_1$ and $\overline{S_1}$ are HIGH (e.g. 5 volts) or low (0 volt) in accordance with the potential of the signal $SEL_1$.

The semiconductor memory device of Fig. 2 comprises a NOR gate circuit portion 6, an inverter circuit portion 5, an output buffer portion 4, a sense circuit 3, a column gate 2 and a memory Cells No. 1. The NOR gate circuit portion 6 comprises double gate FAMOS type FETs 312, 313, 314 and 315, an FET 311, an FET 323 and an FET 316.

The inverter circuit portion 5 comprises FETs 317 and 318. The output buffer portion 4 comprises FETs 319, 320, 321 and 322. The output signal $S_\ell$ of the inverter circuit portion 5 is applied to an input terminal of the output buffer portion 4.

In the NOR gate circuit portion 6, the drains of the FETs 312, 313, 314 and 315 are connected to the voltage source $V_{cc}$ through series connected FETs 323 and 311 and to the voltage source $V_{pp}$ through a FET 316. In the writing-in mode, the potential of the signal PRG is HIGH (e.g. 25 volts) and the potential of the signal $\overline{PRG}$ is LOW (0 volt), while in the chip selection mode, the potential of the signal PRG is LOW (0 volt) and the potential of the signal $\overline{PRG}$ is HIGH (e.g. 5 volts). The writing-in of the chip selection logic is carried out usually simultaneously with the writing-in of the information to the memory. The potentials of the signals $SEL_1$ and $SEL_2$ are such that the memory cell in question is selected when the signals $SEL_1$ and $SEL_2$ assume

said potentials. The potentials of the signals $SEL_1$ and $SEL_2$ must be maintained while the writing-in of the information to the memory is being carried out.

The HIGH potential of the signal $SEL_1$ and the LOW potential of the signal $SEL_2$ are used, in order to realize the chip selection logic in which the memory chip 1 is selected by the HIGH potential $SEL_1$ signal and the LOW potential $SEL_2$ signal. Under this condition, in the writing-in mode, the potential of the signal PRG becomes HIGH (e.g. 25 volts) and the potential of the signal $\overline{PRG}$ becomes LOW (0 volt), and accordingly the potential of the signals $S_1$ and $\overline{S_2}$ become HIGH, which is equal to 25 volts minus the threshold voltage of the FET 110 or the FET 208, and the potential of the signal $\overline{S_1}$ and $S_2$ become LOW (0 volt). Electrons are injected into the floating gates of the FETs 312 and 315 in accordance with the well-known operative characteristic of the floating gate type EPROM, due to the application of a HIGH (approximately 20 volts) voltage to the drains of the FETs the gate potentials of which are HIGH. Accordingly, the threshold voltages of the FETs 312 and 315 are caused to shift to the positive value of, for example, 8 volts. While, no electrons are injected into the floating gates of the FETs 313 and 314 the gate potentials of which are LOW. Accordingly, the threshold voltages of the FETs 313 and 314 undergo no change and are mainatained in the original value of, for example, 2 volts.

After a chip selection logic is written in the NOR gate circuit portion 6 with the aid of the control circuits 7 and 8 of Figs. 3A and 3B, the data stored in the Cells No. 1 is read out as the output signal $S_{out}$ at the output terminal of the output buffer circuit 4 only when a predetermined set of signals $SEL_1$ and $SEL_2$ are supplied to the gates of the FETs 102 and 202. When the potential of the signal $SEL_1$ is HIGH and the potential of the signal $SEL_2$ is LOW, the potentials of the signals $S_1$ and $\overline{S_2}$ are HIGH (e.g. 5 volts) and the potentials of the signals $\overline{S_1}$ and $S_2$ are LOW (0 volt), and all of the FETs 312, 313, 314 and 315 are brought to the cut-off state, because the threshold voltages of the FETs 312 and 315 are higher than said HIGH potential (e.g. 5 volts). Thus the potential of the signal $S_\ell$ becomes LOW (0 volt), and both the FET 319 and the FET 320 are brought to the cut-off state. Accordingly, the output signal $S_{out}$ which corresponds to the information stored in the memory cells 1 is obtained.

When the potential condition of the signals $SEL_1$ and $SEL_2$ is other than the above assumed condition, at least one of the potentials of the signals $S_1$ and $\overline{S_2}$ is HIGH (e.g. 5 volts), and at least one of the FETs 313 314 is brought to the ON state. Thus the potential of the signal $S_\ell$ becomes HIGH (e.g. 5 volts), and the FETs 319 and 320 are brought to the ON state and the FETs 321 and 322 are brought to the cut-off state. Accordingly, no output signal $S_{out}$ is obtained.

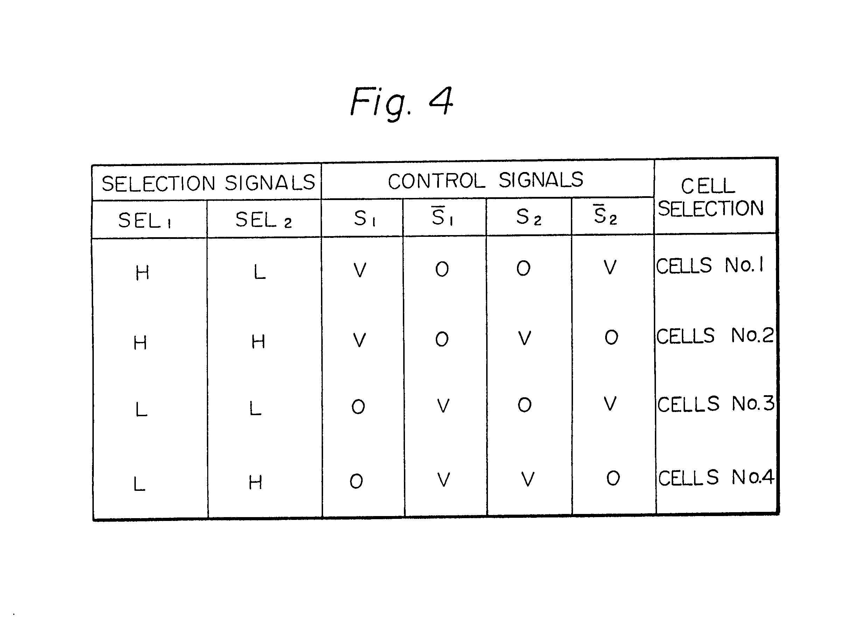

Similarly, the chip selection logic will be written in to the chips so that the Cells No. 2 is selected under the condition that both the selection signals $SEL_1$ and $SEL_2$ are in HIGH state, the Cells No. 3 is selected under the condition that both the selection signals $SEL_1$ and $SEL_2$ are in LOW state, and the Cells No. 4 is selected under the condition that the selection signal $SEL_1$ is in LOW state and the selection signal $SEL_2$ is in HIGH state. The manner of cell selection described above is tabulated in Fig. 4.

Thus, if the chip selection logic has been stored in the device of Fig. 2, the data in the memory cells in question can be read out by applying the signals $SEL_1$ and $SEL_2$ which corresponds to the higher bit portions of the address signal, without providing external decoder circuits.

The erasure of the chip slection logic stored in the device of Fig. 2 is carried out by means of, for example, the irradiation of the ultra-violet ray, simultaneously with the erasure of the data stored in the memory cells. In this case, electrons stored in the floating gates in the FAMOS type FETs 312 through 315 are also eliminated by the ultra--violet irradiation. Accordingly, it is possible to set a new logic state of the FETs of the NOR gate circuit portion 6 when the next data are written-in to the Cells Nos. 1 through 4. Thus, the change of logic state of the FETs of the NOR gate circuit portion 6 is available.

If it is desired that one of the Cells Nos. 1 through 4 is always selected, as in the case of the so-called "DON'T CARE" selection, such selection can be achieved by bringing all of the FETs 312, 313, 314 and 315 to the inoperative state by effecting the writing-in twice with a HIGH and a LOW level signal.

CLAIMS

1. A semiconductor memory device in which the selection of a memory chip is carried out in accordance with the logic of the external selection signals, characterized in that a decoder circuit for receiving said external selection signals for selecting a memory chip is provided in said chip, said decoder circuit performing the selection of said memory chip in accordance with a logic corresponding to the combination of said external selection signals, said logic being capable of being changed by the user of said semiconductor memory device.

2. A semiconductor memory device in which the selection of a memory chip is carried out in accordance with the logic of the external selection signals, characterized in that a control circuit for producing both a first pair of a signal and its inverted signal in the writing-in mode and a second pair of a signal and its inverted signal in the chip selection mode, and a decoder circuit for receiving said first or second pair of the signals for causing the writing-in to said memory chip or the selection of said memory chip, are provided in said memory chip, whereby the writing-in of data to said memory chip is carried out by applying said first pair of signals in the writing-in mode to said decoder circuit and the selection of said memory chip is carried out by applying said second pair of signals in the chip selection mode to said decoder circuit.

3. A semiconductor memory device as defined in Claim 2, wherein said control circuit comprises an inverter circuit including a plurality of transistors and an output control circuit including a plurality of transistors to the gates of which the variable gate voltage is applied.

4. A semiconductor memory device as defined in Claim 2, wherein said decoder circuit has control circuits including a plurality of transistors to the gates of which the variable gate voltage is applied.

5. A semiconductor memory device as defined in Claim 3 or 4, wherein the value of said variable gate voltage is high in the writing-in mode, and is zero in the
chip selection mode.

## Fig. IA

SEL

EXTERNAL DECODER

CS  CH-1
ADR

CS  CH-2
ADR

CS  CH-3
ADR

CS  CH-4
ADR

## Fig. IB

SEL

$CS_1$  $\overline{CS_2}$  CH-1
ADR

$CS_1$  $CS_2$  CH-2
ADR

$\overline{CS_1}$  $CS_2$  CH-3
ADR

$\overline{CS_1}$  $CS_2$  CH-4
ADR

Fig. 2

2/4

0028916

## Fig. 3A

## Fig. 3B

## Fig. 4

| SELECTION SIGNALS | | CONTROL SIGNALS | | | | CELL SELECTION |
|---|---|---|---|---|---|---|
| SEL$_1$ | SEL$_2$ | S$_1$ | $\overline{S}_1$ | S$_2$ | $\overline{S}_2$ | |
| H | L | V | O | O | V | CELLS No.1 |
| H | H | V | O | V | O | CELLS No.2 |
| L | L | O | V | O | V | CELLS No.3 |
| L | H | O | V | V | O | CELLS No.4 |